# EUROPÄISCHE PATENTSCHRIFT

(11) **EP 0 536 560 B1**
(45) Veröffentlichungstag und Bekanntmachung des Hinweises auf die Patenterteilung: **12.06.1996**
(21) Anmeldenummer: 92115662.6
(22) Anmeldetag: 14.09.1992
(51) Int. Cl.: H05K 7/14

(54) **Ein- und/oder Ausgabegerät für Prozessdaten**
In- and/or output device for process data
Dispositif d'entrée ou/et sortie pour données de processus

(30) Priorität: 11.10.1991 CH 2998/91
(43) Veröffentlichungstag der Anmeldung: 14.04.1993
(73) Patentinhaber: ASEA BROWN BOVERI AG, CH-5401 Baden (CH)
(72) Erfinder: Gasser, Markus, CH-5242 Unterehrendingen (CH); Hänsli, Markus, CH-4658 Däniken (CH); Schilling, Robert, CH-5443 Niederrohrdorf (CH); Schneeberger, Stefan, CH-3612 Steffisburg (CH)

(56) Entgegenhaltungen:
- EP-A- 0 067 757
- EP-A- 0 165 434
- DE-U- 8 628 199
- DE-U- 8 800 430
- US-A- 3 052 821

## Beschreibung

### TECHNISCHES GEBIET

Bei der Erfindung wird ausgegangen von einem Ein- und/oder Ausgabegerät für Prozessdaten mit einem Baugruppenträger, mindestens einer auf dem Baugruppenträger befestigten Baugruppe und einem an der Frontseite in die mindestens eine Baugruppe einführbaren Prozessstecker, bei der die mindestens eine Baugruppe mindestens eine in einem Gehäuse angeordnete und mit dem Prozessstecker sowie einem Busstecker elektrisch leitend verbundene Leiterplatte sowie eine mit dem Prozessstecker kraftschlüssig verbundene Steckerleiste zur Aufnahme von Kontaktstiften, die mit Kontakten des Prozesssteckers zusammenwirken, aufweist.

Solche Ein- und/oder Ausgabegeräte weisen an einem Baugruppenträger befestigte und über Prozessstecker sowie Kabel an eine Vorrichtung zur Durchführung eines Prozesses geführte Baugruppen auf, welche untereinander über einen Systembus kommunizieren. Die Baugruppen enthalten jeweils mindestens eine in einem Gehäuse angeordnete Leiterplatte und nehmen Signale von Signalgebern der Prozessdurchführungsvorrichtung auf, verarbeiten die Signale, gegebenenfalls unter Berücksichtigung von Signalen, die von anderen Baugruppen abgegeben werden, und/oder führen Signale Signalaufnehmern der Prozessdurchführungsvorrichtung Zu. Je nach Anforderung kann eine Baugruppe Eingabe-, Ausgabe-, Ein- und Ausgabe- und/oder Verarbeitungsfunktion erfüllen. Die Eigenschaften des Gerätes werden im wesentlichen durch die Funktionen der einzelnen Baugruppen bestimmt. Das Gerät und damit insbesondere auch jede einzelne Baugruppe darf unter der Einwirkung elektromagnetischer Störungen weder beschädigt noch in seiner Funktion beeinträchtigt werden. Dies wird im allgemeinen dadurch erreicht, dass auf das Gerät zufliessende, meist hochfrequente Störströme vor den Eintreten in Schaltkreise, die in einer der Baugruppen vorgesehen sind, durch Schutzvorrichtungen gegen Erde abgeleitet werden. Gegen die Einkoppelung von nichtleitungsgebundenen Störungen werden die Schaltkreise durch Abschirmungen geschützt.

### STAND DER TECHNIK

Ein Ein- und/oder Ausgabegerät der eingangs genannten Art ist beispielsweise aus EP-A-165434 bekannt. Bei diesem oder bei vergleichbaren Geräten werden die Gehäuse der Baugruppen üblicherweise aus Kunststoff gefertigt. Unerwünschte über den Prozessstecker in eine Baugruppe eingeleitete Störströme werden durch Leiterbahnen, die auf der Leiterplatte angeordnet sind, oder durch einen in das Gehäuse der Baugruppe eingelegten Erdleiter vom Signaleingang an der Frontseite zu einem mit dem Baugruppenträger kontaktierten Erdanschluss der Baugruppe geleitet. Am Gehäuse sind üblicherweise zusätzlich Metallbeschichtungen oder Einlegebleche vorgesehen. Durch diese Massnahmen werden auf der Leiterplatte vorgesehene Schaltkreise gegen unerwünschte elektromagnetische Strahlung abgeschirmt und soll dadurch die volle Funktionsfähigkeit der Schaltkreise erhalten werden.

### DARSTELLUNG DER ERFINDUNG

Die Erfindung, wie sie im Patentanspruch 1 definiert ist, löst die Aufgabe, ein Ein- und/oder Ausgabegerät der eingangs genannten Art zu schaffen, welches auch bei starken mechanischen und elektromagnetischen Belastungen eine hohe Betriebssicherheit aufweist.

Das Ein- und/oder Ausgabegerät nach der Erfindung zeichnet sich durch eine äusserst hohe elektromagnetische Verträglichkeit aus. Dem Gerät über die Prozessstecker zufliessende Störströme können unmittelbar hinter dem Prozessstecker auf die breitflächige und damit niederimpedante Bezugsmasse des aus Metallblech gebildeten Gehäuses einer Baugruppe geleitet werden und können dann unmittelbar gegen Erde abfliessen. Durch die niederimpedante Masseleitung entsteht lediglich ein kleiner Spannungsabfall. Daher weist das Gerät nach der Erfindung eine wesentlich höhere Störfestigkeit auf als ein Gerät mit einem verhältnismässig gering dimensionierten Masseleiter. Entsprechend vorteilhaft wirkt sich in diesem Zusammenhang auch aus, dass durch die geringe Stromdichte eines möglicherweise auftretenden Störstromes zugleich auch die Stärke des zugeordneten, in die Schaltkreise eingekoppelten magnetisches Störfeldes gering ist. Ein weiterer Vorteil besteht darin, dass strahlungsgebundene Störungen bereits durch das metallische Gehäuse jeder Baugruppe abgeschirmt werden, zu kontaktierende Einlegeplatten und metallbeschichtete Kunststoffgehäuse also entbehrlich sind.

### WEG ZUR AUSFÜHRUNG DER ERFINDUNG

Die Erfindung wird nachfolgend anhand von Zeichnungen näher erläutert. Hierbei zeigt:
- Fig. 1: eine perspektivische Ansicht einer vereinfacht dargestellten Ausführungsform des Ein- und/oder Ausgabegerätes nach der Erfindung,
- Fig. 2: eine perspektivische Ansicht der wesentlichen Bestandteile einer Baugruppe des Ein- und/oder Ausgabegerätes nach Fig.1,
- Fig. 3: eine Seitenansicht einer Baugruppe des Ein- und/oder Ausgabegerätes nach Fig.1, bei welcher Teile des Baugruppengehäuses entfernt worden sind, und
- Fig.4: eine Aufsicht auf einen längs IV-IV geführten Schnitt durch eine Baugruppe nach Fig.3.

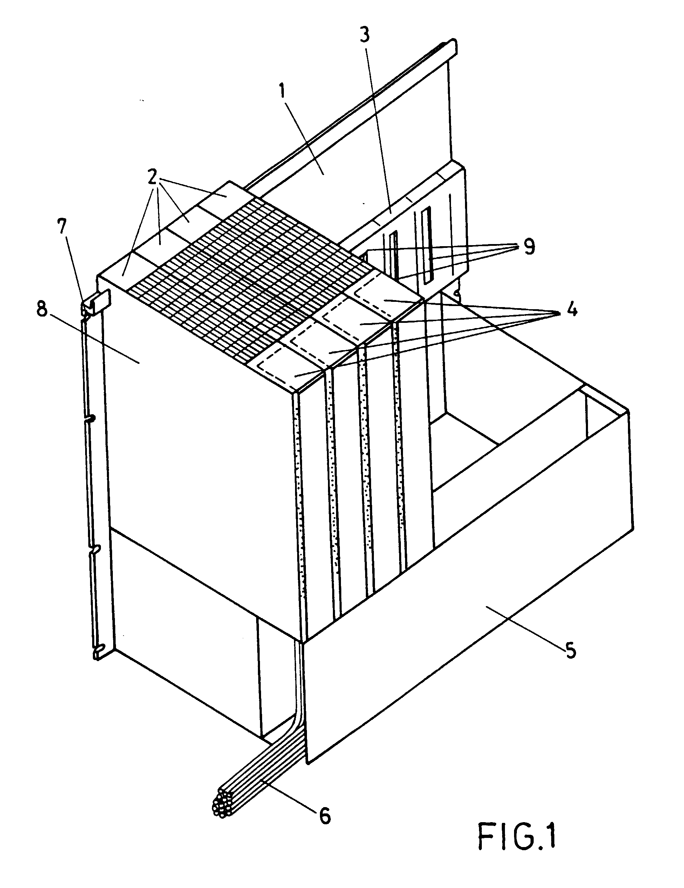

Das in Fig.1 dargestellte Ein- und/oder Ausgabegerät besteht aus nebeneinander auf einen Baugruppenträger 1 montierten, im wesentlichen kastenförmigen Baugruppen 2, von denen aus Gründen der Einfachheit lediglich nur gleichartig ausgebildete dargestellt sind, dem Baugruppenträger 1 mit einem Bushalter 3 und Prozesssteckern 4. Die Prozessstecker 4 können von den Baugruppen 2 abgekuppelt werden und sind über in einem Kanal 5 geführte Kabel 6 mit nicht dargestellten Signalquellen und Signalaufnehmern einer ebenfalls nicht dargestellten Vorrichtung zur Durchführung eines Prozesses, beispielsweise eines Herstell- oder eines Bearbeitungsverfahrens, verbunden. Auf der Rückseite der Baugruppen 2 befindet sich im oberen Teil jeweils ein metallenes Befestigungselement 7 sowie ein aus Fig.1 nicht ersichtlicher Busstecker. Das Befestigungselement 7 greift grossflächig in den Baugruppenträger 1 sowie das Gehäuse 8 der Baugruppe 2 ein. Bei der Montage wird jede Baugruppe 2 in das Befestigungselement 7 eingeführt und mit ihrer Rückseite an den Baugruppenträger 1 geschwenkt und anschliessend durch eine nicht ersichtliche Verschraubung vollständig fixiert. Beim Schwenken bilden der Busstecker und eine am Bushalter 3 vorgesehene Buskupplung 9 eine Steckverbindung, über welche Signale in den vom Bushalter 3 getragenen Bus und damit zu anderen Baugruppen 2 geführt werden und/oder aus dem Bus und damit aus anderen Baugruppen 2 entnommen werden können. Baugruppenträger 1 und Baugruppe 2 bestehen überwiegend aus Metall und sind nach dem Verschwenken unmittelbar miteinander und mittelbar über das Befestigungselement 7 elektrisch leitend verbunden.

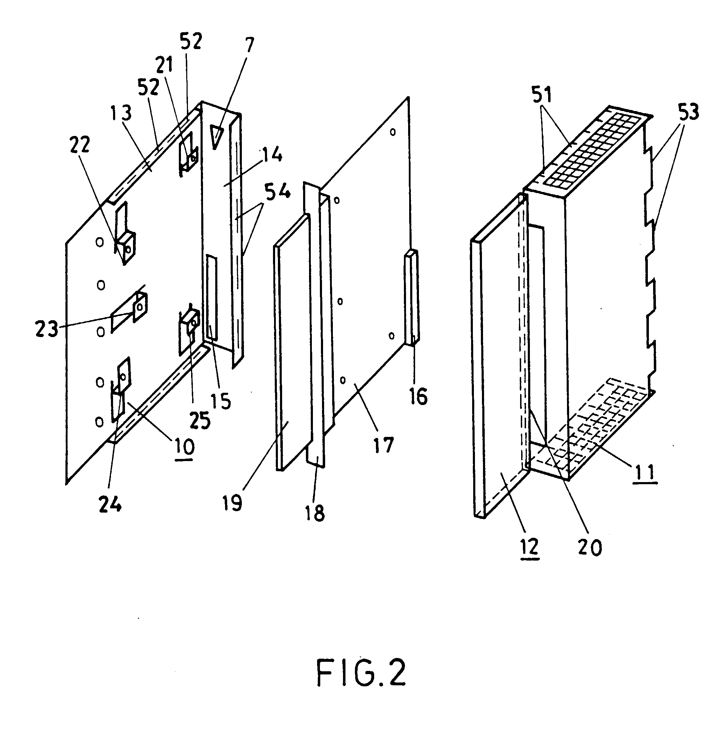

Jede Baugruppe enthält gemäss Fig.2 ein aus einem Tragteil 10 sowie Abdeckungen 11, 12 gebildetes Gehäuse. Das Tragteil 10 ist im wesentlichen von zwei zueinander L-förmig angeordneten Platten gebildet, von denen die eine als Seitenwand 13 und die andere als Rückwand 14 des Baugruppengehäuses 2 verwendet wird. Im oberen Teil der Rückwand 14 ist eine nicht bezeichnete Oeffnung vorgesehen, die das Befestigungselement 7 aufnimmt. Ferner weist die Rückwand 14 eine Oeffnung 15 auf, welche der Durchführung eines Bussteckers 16 dient. Der Busstecker 16 ist auf dem Tragteil 10 lagerbar und weist mit nicht dargestellten Leiterbahnen einer Leiterplatte 17 kontaktierte und ebenfalls nicht dargestellte Anschlussstifte auf. Die Leiterplatte 17 ist mit einer auf dem Tragteil 10 abstützbaren Steckerleiste 18 mit nicht dargestellten Anschlussstiften, welche mit Anschlussbuchsen des Prozessteckers 4 zusammenwirken, sowie mit mindestens einer nicht dargestellte Anzeigedioden tragenden Leiterplatte 19 verbunden. Beim Zusammenbau der Baugruppe 2 wird die Steckerleiste 18 auf dem Tragteil 10 fixiert und werden die damit verbundenen Leiterplatten 17 und 19 durch Aufschnappen der Abdeckungen 11 und 12 in das hierbei gebildete Baugruppengehäuse 8 eingeschlossen. Eine in der Abdeckung 11 vorgesehene Oeffnung 20 dient der Durchführung der Steckerleiste 18.

Das Tragteil 10 und die Abdeckung 11 des Baugruppengehäuses 2 sind aus elektrisch leitendem Metallblech, insbesondere aus Stahlblech, geformt, wohingegen die Abdeckung 12 aus Isolierstoff gebildet ist. In das Metallblech des Tragteils 11 sind dem Tragen der Leiterplatte 17 dienende Ansätze 21, 22, 23, 24 und 25 unter Bildung einer für elektromagnetische Strahlung undurchlässigen Öffnung eingeformt. Ein Teil dieser Ansätze, nämlich die Ansätze 22, 23 und 24, stehen nach dem Zusammenbau der Baugruppe 2 mit einer Leiterbahn der Leiterplatte 17 in elektrisch leitender Verbindung.

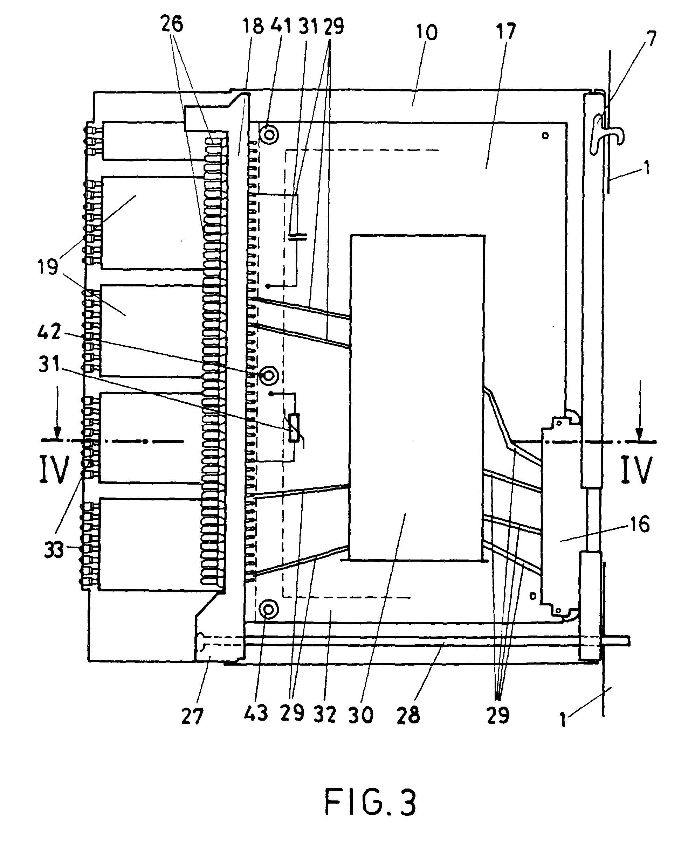

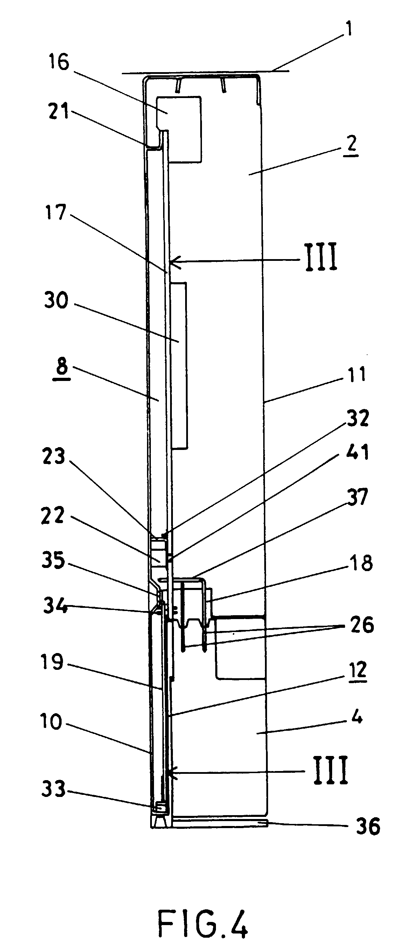

Aus den Figuren 3 und 4 ist die genauere Ausbildung einer Baugruppe 2 ersichtlich. So ist aus Fig.3 (Seitenansicht nach Entfernen der Abdeckungen 11,12) zu erkennen, dass die Steckerleiste 18 Kontaktstifte 26 sowie ein gegebenenfalls auch am Tragteil 10 vorsehbares Lagerelement 27 und eine Spannschraube 28 trägt, dass auf der dem Betrachter zugewandten Seite der Leiterplatte 17 Leiterbahnen 29, Schaltkreise 30 und Schutzelemente 31 vorgesehen sind, dass auf der vom Betrachter abgewandten Seite der Leiterbahn 17 eine zumindest abschnittsweise parallel zur Steckerleiste 18 zwischen der Steckerleiste und den Schaltkreisen 30 eine (gestrichelt dargestellte) Leiterbahn 32 aufgebracht ist, und dass ferner mehrere mit den Kontaktstiften 26 elektrisch leitend verbundene und von Leiterplatten 19 getragene Anzeigedioden 33 vorgesehen sind. In die Leiterplatte 17 sind ferner Hohlkontakte 41, 42, 43 eingelassen, die einen grossflächigen elektrischen Kontakt mit der Leiterbahn 32 aufweisen. Die Schutzelemente 31 sind vorzugsweise jeweils als Kondensator, Überspannungsableiter oder Diode ausgebildet und sind jeweils mit einem ersten Stromanschluss mit der Leiterbahn 32 und mit einem zweiten Stromanschluss mit einem der Kontaktstifte 26 elektrisch leitend verbunden.

Aus Fig.4 (Aufsicht auf einen längs IV-IV geführten Schnitt durch die Baugruppe 2, wobei im Gegensatz zu Fig.3 die Abdeckungen 11 und 12 eingesetzt sind und der Prozessstecker 4 in die Baugruppe 2 eingeschwenkt ist) ist zu ersehen, dass die Leiterplatte 17 über Kontaktteile 34 mit den Leiterplatten 19 elektrisch und mechanisch verbunden ist, dass die Steckerleiste 18 mittels Schrauben 35 mechanisch fest mit dem Tragteil 10 des Gehäuses der Baugruppe 2 verbunden ist, dass die Leiterplatte 17 auf den Ansätzen 21 bis 25, befestigt ist, wobei die Befestigung etwa mittels Schrauben erfolgt, welche jeweils durch ein in jedem Ansatz, z.B. 22, vorgesehenes Auge in den auf der Leiterplatte 17 eingelassenen Hohlkontakte, z. B. 41, geführt sind, und dass der eingeschwenkte Prozessstecker 4 von einer Tür 36 abgedeckt ist, die schwenkbar an der am Tragteil 10 eingeschnappten Abdeckung 12 angebracht ist. Ferner ist ersichtlich, dass die Kontaktstifte 26 gekrümmt ausgebildete, elastisch verformbare Anschlussteile 37 enthalten, an denen die Leiterplatte 17 vorzugsweise mittels Einpresstechnik abgestützt ist.

Das erfindungsgemässe Ein- und/oder Ausgabegerät wirkt wie folgt: Zur Inbetriebnahme wird nach Einschwenken und Fixieren der Baugruppe 2 mittels des Befestigungelementes 7 und der Spannschraube 28 am Baugruppenträger 1 zunächst der Prozessstecker 4 mit einem Lagerelement auf dem Lagerelement 27 der Steckerleiste 18 aufgesetzt und durch eine in der Zeichenebene gemäss Fig.3 erfolgende Drehbewegung in die in Fig.4 dargestellte Position geführt. Hierbei kontaktieren nicht dargestellte und mit den Kabeln 6 elektrisch leitend verbundene Kontakte des Prozesssteckers 4 die Kontaktstifte 26 und stellen somit über die Leiterbahnen 29 und die Schaltkreise 30 eine elektrische Wirkverbindung zwischen den Signalgebern und/oder Signalaufnehmern der Vorrichtung zur Durchführung des Prozesses und dem Bus bzw. anderen Baugruppen 2 her.

Da durch die Kabel 6 gegebenenfalls auch mechanische Kräfte übertragen werden, wird der eingeschwenkte Prozessstecker 4 beispielsweise mittels einer von der Tür 36 abgedeckten und auf die Steckerleiste 18 wirkende Verschraubung gegen unerwünschte Bewegung gesichert. Die von den Kabeln 6 herbeigeführten mechanischen Kräfte werden über den Prozessstecker 4, die Steckerleiste 18 und das Tragteil 10 auf den Baugruppenträger 1 übertragen. Die Leiterplatte 17 ist daher während des Betriebes des Gerätes weitgehend verschont von mechanischen Belastungen.

Die auf der Leiterplatte 17 angeordneten Schaltkreise 30 bleiben weitgehend unbeeinflusst von elektromagnetischen Störungen. Über den Prozessstecker 4 zugeführte überwiegend hochfrequente Störströme werden durch die unmittelbar an den Kontaktstiften 26 angeordneten Schutzelemente 31 aus dem Strompfad zu den Schaltkreisen 30 ausgekoppelt und über die breitflächig ausgebildete Leiterbahn 32 und die Ansätze 22, 23 und 24 auf kurzem Wege in das Tragteil 10 das geerdete Baugruppengehäuses 8 geleitet. Der Strompfad für diese Störströme weist eine äusserst geringe Impedanz auf, da alle Stromleiter kurz und breitflächig ausgebildet sind. Daher ist die gegen Erde abfliessende Störstromdichte gering und wird demnach auch bei grossen Störströmen praktisch kein durch die Störströme hervorgerufenes Magnetfeld in die Schaltkreise 30 eingekoppelt. Eine besonders günstige Führung des Störstromes wird dann erreicht, wenn die Ansätze, wie etwa die Ansätze 22 und 24, U-Profil aufweisen, da dann die Störströme von der Leiterbahn 32 bevorzugt in die aussenliegende Fläche des Tragteils 10 des Baugruppengehäuses geführt werden, und die innenliegende, der Leiterplatte 17 zugewandte Fläche des Baugruppengehäuses stromfrei bleibt und somit eine zusätzliche Schirmfunktion ausübt. Im allgemeinen reicht jedoch eine Ausbildung der Ansätze, wie beispielsweise der Ansatz 23, mit Z-Profil aus, um eine ausreichend gute Führung der Störströme zu gewährleisten. Das aus Metallblech bestehende Gehäuse schirmt darüber hinaus strahlungsgebundene Störungen besonders wirkungsvoll ab. Zusätzliche metallene Einlegeplatten und/ oder metallene Beschichtungen des Baugruppengehäuses sind daher entbehrlich.

Wie etwa aus Fig. 3 ersichtlich ist, ist das Tragteil 10 des Baugruppengehäuses 8 derart weit in die einem Bediener des Ein- und/oder Ausgabegerätes zugängliche Seite vorgezogen, dass das der berührbaren Oberfläche nächstliegende leitende Teil nicht ein Stromanschluss eines von der Bedienerseite des Gerätes zugänglichen Bedien- und/oder Anzeigeelementes, wie etwa der Anzeigediode 33, sondern immer ein Teil dieses Gehäuses ist. Hierdurch wird erreicht, dass durch elektrostatische Entladungen verursachte Störströme direkt über das Baugruppengehäuse 8 und mit grosser Sicherheit nicht durch die Stromkreise 30 gegen Erde abfliessen. Daher können Schutzbeschaltungen für die Bedien- und Anzeigeelemente entfallen. Durch elektrostatische Entladungen verursachte hochfrequente Störströme fliessen über die aus isolierendem Material bestehende Abdeckung 12 des Baugruppengehäuses 8 in die äusseren Flächen des Tragteils 10 und der Abdeckung 11 grossflächig und damit niederimpedant gegen Erde ab. Der hochfrequente Strom fliesst hierbei wegen des Skineffektes nur auf der äusseren Oberfläche des Baugruppengehäuses 8. Die Innenseite wird nicht vom Strom durchflossen und wirkt somit als Abschirmung für elektrische und magnetische Felder, die durch den auf der Aussenseite fliessende Strom verursacht werden.

Bei der Ausgestaltung des Baugruppengehäuses 8 empfiehlt es sich, Tragteil 10 und Abdeckung 11 derart auszubilden, dass sie nach dem Zusammenbau des Gerätes grossflächig miteinander verrastet sind. Dies wird gemäss Fig.2 mit Vorteil dadurch erreicht, dass in den Rand einander gegenüberstehender und parallel zueinander verlaufender Ausformungen des Tragteils 10 und der Abdeckung 11 federnd ausgebildete Rastnasen 51 und die Rastnasen beim Verrasten fixierende Vertiefungen 52 angeordnet sind. Zudem sind in das Tragteil 10 bzw. in die Abdeckung 11 jeweils ein Lagerelement 53 bzw. 54 eingeformt ist. Diese Lagerelemente wirken nach Art eines Schwenkgelenks zusammen und sind bis zum Verrasten der Abdeckung 11 und des Tragteils 10 verschwenkbar.

## Patentansprüche

1. Ein- und/oder Ausgabegerät für Prozessdaten mit einem Baugruppenträger (1), mindestens einer auf dem Baugruppenträger (1) befestigten Baugruppe (2) und einem an der Frontseite in die mindestens eine Baugruppe (2) einführbaren Prozessstecker (4), bei der die mindestens eine Baugruppe (2) mindestens eine in einem Gehäuse angeordnete und mit dem Prozessstecker (4) sowie einem Busstecker (16) elektrisch leitend verbundene Leiterplatte (17) sowie eine mit dem Prozessstecker kraftschlüssig verbundene Steckerleiste (18) zur Aufnahme von Kontaktstiften (26), die mit Kontakten des Prozesssteckers (4) zusammenwirken, aufweist, dadurch gekennzeichnet, dass das Baugruppengehäuse (8) überwiegend aus Metallblech gebildet ist und aus dem Metallblech geformte, dem Tragen der Leiterplatte (17) dienende Ansätze (21, 22, 23, 24, 25) aufweist, von denen ein Teil mit einer Leiterbahn (32) der Leiterplatte (17) in elektrisch leitender Verbindung steht, und dass das Baugruppengehäuse (8) mit einem metallenen und auf Erdpotential befindlichen Teil des Baugruppenträgers (1) kontaktiert ist.

2. Ein- und Ausgabegerät nach Anspruch 1, dadurch gekennzeichnet, dass das Baugruppengehäuse (8) ein am geerdeten Teil des Baugruppenträgers (1) lösbar befestigtes Tragteil (10) enthält.

3. Ein- und/oder Ausgabegerät nach einem der Ansprüche 1 oder 2, dadurch gekennzeichnet, dass das Tragteil (10) des Baugruppengehäuse (8) derart weit in die einem Bediener des Ein- und/oder Ausgabegerätes zugängliche Seite vorgezogen ist, dass das der berührbaren Oberfläche des Baugruppengehäuses (8) nächstliegende leitende Teil nicht ein Stromanschluss eines von der Bedienerseite des Gerätes zugänglichen Bedien- und/oder Anzeigeelementes (Anzeigedioden 33), sondern immer ein Teil dieses Gehäuses ist.

4. Ein- und/oder Ausgabegerät nach Anspruch 1, dadurch gekennzeichnet, dass das Bedien- und Anzeigeelement (Anzeigediode 33) unter einer überwiegend aus Isoliermaterial bestehenden Abdeckung (12) des Baugruppengehäuses (8) angeordnet ist.

5. Ein- und/oder Ausgabegerät nach einem der Ansprüche 1 bis 4, dadurch gekennzeichnet, dass das Baugruppengehäuse (8) zusätzlich eine mit dem Tragteil (10) grossflächig verrastete Abdeckung (11) aufweist.

6. Ein- und/oder Ausgabegerät nach Anspruch 5, dadurch gekennzeichnet, dass in den Rand einander gegenüberstehender und parallel zueinander verlaufender Ausformungen des Tragteils (10) und der aus Metallblech gebildeten Abdeckung (11) federnd ausgebildete Rastnasen (51) und die Rastnasen beim Verrasten fixierende Vertiefungen (52) angeordnet sind.

7. Ein- und/oder Ausgabegerät nach Anspruch 6, dadurch gekennzeichnet, dass in das Tragteil (10) und in die Abdeckung (11) jeweils ein Lagerelement (53, 54) eingeformt ist, dass diese Lagerelemente (53, 54) nach Art eines Schwenkgelenks zusammenwirken und bis zum Verrasten der Abdeckung (11) und des Tragteils (10) verschwenkbar sind.

8. Ein- und/oder Ausgabegerät nach einem der Ansprüche 1 bis 7, dadurch gekennzeichnet, dass zumindest ein Teil der Ansätze (22, 23, 24) jeweils unter Bildung einer Öffnung aus dem Metallblech geformt sind.

9. Ein- und/oder Ausgabegerät nach einem der Ansprüche 1 bis 8, dadurch gekennzeichnet, dass zumindest ein Teil der mit der Leiterbahn (32) in elektrisch leitender Verbindung stehenden Ansätze (22, 24) U-Profil aufweist.

10. Ein- und/oder Ausgabegerät nach einem der Ansprüche 1 bis 9 mit auf der Leiterplatte (17) befindlichen Schaltkreisen (30), dadurch gekennzeichnet, dass die Leiterbahn (32) parallel zur Steckerleiste (18) zwischen der Steckerleiste (18) und den Schaltkreisen (30) angeordnet ist.

11. Ein- und/oder Ausgabegerät nach Anspruch 10, dadurch gekennzeichnet, dass auf der Leiterplatte (17) mindestens ein Schutzelement (31) vorgesehen ist, welches mit einem ersten Stromanschluss mit der Leiterbahn (22) und mit einem zweiten Stromanschluss mit einem der Kontaktstifte (26) elektrisch leitend verbunden ist.

## Claims

1. Input and/or output device for process data, having a mounting rack (1), at least one module (2) fastened on the mounting rack (1) and a process connector (4) which can be inserted into the at least one module (2) on the front side, in which the at least one module (2) has at least one circuit board (17) which is arranged in a housing and is electroconductively connected to the process connector (4) and to a bus connector (16), as well as a terminal strip (18), connected non-positively to the process connector, for receiving contact pins (26) which interact with contacts of the process connector (4), characterized in that the module housing (8) is predominantly formed from metal plate and has lugs (21, 22, 23, 24, 25) formed out of the metal plate which serve to carry the circuit board (17), some of which lugs are electroconductively connected to a conductor track (32) of the circuit board (17), and in that the module housing (8) is in contact with a metal part of the mounting rack (1) which is at earth potential.

2. Input and/or output device according to Claim 1, characterized in that the module housing (8) contains a support part (10) which is detachably fastened to the earthed part of the mounting rack (1).

3. Input and/or output device according to one of Claims 1 or 2, characterized in that the support part (10) of the module housing (8) is drawn forwards so far into the side accessible to a user of the input and/or output device that the conductive part lying closest to the touchable surface of the module housing (8) is not a current terminal of an operating and/or display element (indicating diodes 33) accessible from the operator side of the device, but is always a part of said housing.

4. Input and/or output device according to Claim 1, characterized in that the operating and display element (indicating diode 33) is arranged under a cover (12), which is made predominantly of insulating material, of the module housing (8).

5. Input and/or output device according to one of Claims 1 to 4, characterized in that the module housing (8) additionally has a cover (11) interlocked with the support part (10) over a large area.

6. Input and/or output device according to Claim 5, characterized in that springy detent noses (51) and depressions (52) which fix the detent noses when interlocked are arranged in the edge of mutually opposite and parallel extending mouldings of the support part (10) and of the cover (11) formed from metal plate.

7. Input and/or output device according to Claim 6, characterized in that in each case a bearing element (53, 54) is formed into the support part (10) and into the cover (11), and in that said bearing elements (53, 54) interact in the manner of a swivel joint and can be pivoted until the cover (11) and the support part (10) interlock.

8. Input and/or output device according to one of Claims 1 to 7, characterized in that at least some of the lugs (22, 23, 24) are formed out of the metal plate, in each case forming an opening.

9. Input and/or output device according to one of Claims 1 to 8, characterized in that at least some of the lugs (22, 24) electroconductively connected to the conductor track (32) have a U-section.

10. Input and/or output device according to one of Claims 1 to 9 having circuits (30) located on the circuit board (17), characterized in that the conductor track (32) is arranged parallel to the terminal strip (18) between the terminal strip (18) and the circuits (30).

11. Input and/or output device according to Claim 10, characterized in that at least one protective element (31) is provided on the circuit board (17) and is electroconductively connected with a first current terminal to the conductor track (22) and with a second current terminal to one of the contact pins (26).

## Revendications

1. Dispositif d'entrée et/ou de sortie pour données de processus avec un support de modules (1), au moins un module (2) fixé sur le support de modules (1) et un connecteur de processus (4) insérable par la face avant dans au moins un module (2), au moins un module (2) étant ici muni d'au moins un circuit imprimé (17) logé dans un boîtier et relié électriquement avec le connecteur de processus (4) et avec un connecteur de bus (16), ainsi que d'une barrette de connexion (18) reliée par force au connecteur de processus et destinée à recevoir des broches de raccordement (26) qui agissent conjointement avec des contacts du connecteur de processus (4), caractérisé par le fait que le boîtier du module (8) est principalement formé de tôle métallique et présente des embases (21, 22, 23, 24, 25) moulées dans la tôle métallique et servant à porter le circuit imprimé (17), une partie de celles-ci étant en contact électrique avec une piste conductrice (32) du circuit imprimé (17), et que le boîtier du module (8) est en contact avec une pièce métallique du support de modules (1) se trouvant au potentiel de la terre.

2. Dispositif d'entrée et de sortie conforme à la revendication 1, caractérisé par le fait que le boîtier du module (8) comporte une partie porteuse (10) amovible fixée sur une pièce mise à la terre du support de modules (1).

3. Dispositif d'entrée et/ou de sortie conforme à l'une des revendications 1 ou 2, caractérisé par le fait que la partie porteuse (10) du boîtier du module (8) est avancée suffisamment loin vers le côté du dispositif d'entrée et/ou de sortie accessible à un utilisateur pour que la partie conductrice la plus proche de la surface accessible du boîtier du module (8) ne soit pas une connexion électrique d'un élément de commande et/ou d'indication (diode indicatrice 33) accessible du côté utilisateur du boîtier, mais toujours une partie du boîtier lui-même.

4. Dispositif d'entrée et/ou de sortie conforme à la revendication 1, caractérisé par le fait que l'élément de commande et d'indication (diode indicatrice 33) est disposé sous un recouvrement (12) du boîtier du module (8) composé essentiellement de matériau isolant.

5. Dispositif d'entrée et/ou de sortie conforme à l'une des revendications 1 à 4, caractérisé par le fait que le boîtier du module (8) présente en plus un recouvrement (11) verrouillé sur une grande surface avec la partie porteuse (10).

6. Dispositif d'entrée et/ou de sortie conforme à la revendication 5, caractérisé par le fait que dans le bord des moulures opposées et parallèles les unes aux autres de la partie porteuse (10) et du recouvrement (11) en tôle métallique sont disposés des tenons d'arrêt (51) à effet ressort et des évidements (52) fixant les tenons d'arrêt lors de l'enclenchement.

7. Dispositif d'entrée et/ou de sortie conforme à la revendication 6, caractérisé par le fait qu'un élément d'assemblage (53, 54) est à chaque fois moulé dans la partie porteuse (10) ou dans le recouvrement (11), que ces éléments d'assemblage (53, 54) agissent entre eux comme une articulation pivotante et peuvent être pivotés jusqu'à l'enclenchement du recouvrement (11) et de la partie porteuse (10).

8. Dispositif d'entrée et/ou de sortie conforme à l'une des revendications 1 à 7, caractérisé par le fait qu'au moins une partie des embases (22, 23, 24) est à chaque fois réalisée en formant un ouverture dans la tôle métallique.

9. Dispositif d'entrée et/ou de sortie conforme à l'une des revendications 1 à 8, caractérisé par le fait qu'au moins une partie des embases (22, 24) se trouvant en contact électrique avec la piste conductrice (32) présente un profil en U.

10. Dispositif d'entrée et/ou de sortie conforme à l'une, des revendications 1 à 9, avec des circuits de commutation (30) se trouvant sur le circuit imprimé (17), caractérisé par le fait que la piste conductrice (32) est disposée parallèlement à la barrette de connexion (18) entre la barrette de connexion (18) et les circuits de commutation (30).

11. Dispositif d'entrée et/ou de sortie conforme à la revendication 10, caractérisé par le fait qu'au moins un élément de protection (31) est prévu sur le circuit imprimé (17), lequel est relié électriquement par une première borne de connexion avec la piste conductrice (32) et par une deuxième borne de connexion avec l'une des broches de contact (26).
